# EUROPÄISCHE PATENTSCHRIFT

(11) **EP 1 360 512 B1**
(45) Veröffentlichungstag und Bekanntmachung des Hinweises auf die Patenterteilung: **28.07.2004**
(21) Anmeldenummer: 02737636.7
(22) Anmeldetag: 24.01.2002
(51) Int. Cl.: G01R 21/00, G01R 21/133

(54) **KOMPENSATIONSSCHALTUNG FÜR DIE PHASENVERSCHIEBUNG BEI ELEKTRIZITÄTSZÄHLERN ZUM DIREKTEN ANSCHLUSS**
COMPENSATION CIRCUIT FOR THE PHASE SHIFT IN ELECTRICITY METERS FOR DIRECT CONNECTION
CIRCUIT DE COMPENSATION DESTINE AU DEPHASAGE DE COMPTEURS ELECTRIQUES POUR CONNEXION DIRECTE

(30) Priorität: 29.01.2001 DE 10104064
(43) Veröffentlichungstag der Anmeldung: 12.11.2003
(73) Patentinhaber: Landis+Gyr AG, 6300 Zug (CH)
(72) Erfinder: DE VRIES, Jacob, CH-6319 Allenwinden (CH); ULRICH, Adrian, 6390 Engelberg (CH)
(74) Vertreter: Heusch, Christian
(86) Internationale Anmeldenummer: PCT/IB2002/000207
(87) Internationale Veröffentlichungsnummer: WO 2002/061441

(56) Entgegenhaltungen:
- DE-A- 19 639 410
- GB-A- 2 031 166
- US-A- 5 301 121

## Beschreibung

Die Erfindung ist dem Gebiet der Zählertechnik zuzuordnen. Sie betrifft eine Kompensationsschaltung für die Phasenverschiebung zwischen der Spannungserfassung und der Stromerfassung bei Elektrizitätszählern zum direkten Anschluss.

### STAND DER TECHNIK

In Industrieanwendungen haben sich elektronische Elektrizitätszähler bereits wegen ihrer Vorteile gegenüber elektromechanischen Zählern weitgehend durchgesetzt. Der Anschluss dieser Industriezähler erfolgt bekanntermassen indirekt, also über Stromwandler bzw. Spannungswandler, die entsprechende, normgerechte Charakteristiken aufweisen. Als herausragende Eigenschaften elektronischer Zähler sind vor allem die Möglichkeit der Femablesbarkeit zu nennen, die Wartungsfreiheit, die geringeren Geräteabmessungen, die höhere Genauigkeit und der erweiterte Strombereich.

Im Hinblick auf diese gegenüber elektromechanischen Zählern offensichtlichen Vorteilen gewinnt der Einsatz von elektronischen Elektrizitätszählern auch in Haushalten zunehmend an Bedeutung. Ein grundsätzlicher Unterschied zwischen diesen Haushaltszählern und den oben erwähnten Industriezählern ist in ihrer Installationsanordnung zu sehen. So sind Haushalszähler typischerweise direkt angeschlossen; dies bedeutet, dass sie unmittelbar an der Leitung zur anhängenden Last angeschlossen sind. Dabei fällt der Stromerfassung eine Schlüsselrolle zu, da hier die Potentialtrennung zum Zähler erfolgt und zudem hohe Anforderungen gemäss der internationalen Norm IEC 1036 an diese Zähler gestellt werden. Die normgerechten Anforderungen an die Genauigkeit bei der Stromerfassung und der Spannungserfassung Umfassen einen kleinen Amplitudenfehler (<1%), einen kleinen Phasenfehler (<0.3°) und einen kleinen Linearitätsfehler. Darüber hinaus muss eine Gleichstromtoleranz von Iₘₐₓ/π gemäss der genannten Norm erreicht werden; das bedeutet, dass ein solcher elektronischer Elektrizitätszähler bei Mischstrombeaufschlagung mit einem Gleichstromanteil ≤ Iₘₐₓ/π normgerecht weiter messen können muss. Diese elektronischen Elektrizitätszähler zum direkten Anschluss dürfen also nicht durch den Gleichstromanteil von bis zu Iₘₐₓ/π in Sättigung gebracht werden, sondern müssen selbst bei einer derartigen Gleichstromvormagnetisierung noch in der Lage sein, den Wechselanteil des Laststroms bis zu Iₘₐₓ abzubilden..

Gleichstromtolerante Wandler mit einer Gleichstromfestigkeit bis ≤ Iₘₐₓ/π sind zwar bekannt, jedoch werden sie den Anforderungen an eine maximal zulässige Phasenverschiebung nicht gerecht, da bei ihnen Phasenverschiebungen zwischen Strom- und Spannungsmesswerten von bis zu 5° auftreten können. Eine Korrektur mittels Zeitverschiebung, wie sie beispielsweise in der DE 196 39 410 A1 beschrieben ist, kann hier nur eingeschränkt Abhilfe schaffen. Da Haushaltszähler Massenprodukte sind, haben wirtschaftliche Faktoren bei der Auswahl aller Bauteile eine besondere Bedeutung. Deshalb ist eine in konventionellen Zählern installierte Korrektur der Phasenverschiebung lediglich in engen Grenzen mittels Zeitverschiebung möglich, und darüber hinaus ist diese Korrektur mittels Zeitverschiebung nicht an die Frequenz gekoppelt, sodass diese Korrektur für sich betrachtet frequenzabhängig und somit begrenzt ist.

Solange aber Gleichströme in Verbindung mit der Energieverrechnung von den Zählern nicht gemessen, sondern allenfalls "verkraftet" werden müssen, wird die Technik der transformatorisch wirkenden Stromsensoren - insbesondere wegen ihrer einfachen, preiswerten und robusten Ausführung - Bestand haben.

### DARSTELLUNG DER ERFINDUNG

Es ist deshalb Aufgabe der Erfindung eine Kompensationsschaltung für die Phasenverschiebung bei Elektrizitätszähler der oben genannten Art anzugeben, die auch bei Mischstrombeaufschlagung in der Lage ist, die Normgrenzwerte einer Gleichstrombeaufschlagung unbeschadet zu verkraften und dabei innerhalb der Normvorgaben Wirk- bzw. Blindleistung bei allen betriebsüblichen Netzfrequenzen korrekt zu erfassen. Des weiteren besteht die Aufgabe der Erfindung darin, dass diese Kompensationsschaltung robust sein soll und zudem im Sinne einer Massenanwendung einfach und preiswert herstellbar sein soll.

Die Aufgabe der Erfindung wird gelöst durch die Merkmale des Anspruchs 1. Weitere vorteilhafte Ausgestaltungen der Erfindung sind Gegenstand der Unteransprüche.

Der Kern der Erfindung ist darin zu sehen, dass bei Elektrizitätszählern zum direkten Anschluss, die heutzutage mittels eines gleichstromtoleranten Wandlers eine normgerechte Mischstrombeaufschlagung unbeschadet vertragen, eine frequenzunabhängige Kompensation einer Phasenverschiebung zwischen der Strom- und Spannungserfassung mit Hilfe eines Hochpassfilters im Spannungspfad erzielt wird. Ein konventioneller, gleichstromtoleranter Wandler im Strompfad bewirkt durch seine Hochpasscharakteristik eine frequenzabhängige Phasenverschiebung, die durch eine ebenfalls frequenzabhängige Phasenverschiebung des Hochpassfilters im Spannungspfad kompensiert wird. Da die Hochpasscharakteristik des Hochpassfilters an die Hochpasscharakteristik des gleichstromtoleranten Wandlers angepasst ist, erfolgt somit die Kompensation der angesprochenen Phasenverschiebung vorteilhafterweise frequenzunabhängig.

Eine besonders vorteilhafte Ausgestaltung der Erfindung sieht vor, dass das Hochpassfilter einen Widerstand und einen Kondensator umfasst, da ein solches Hochpassfilter einfach, preiswert und robust ist.

Von Vorteil ist, wenn zwischen dem Hochpassfilter und dem Eingang für die Spannungserfassung ein weiterer Widerstand zwecks einer Spannungsteilung angeordnet ist. Des weiteren ist vorteilhafterweise zwischen dem gleichstromtoleranten Wandler und dem Eingang für die Stromerfassung ein Bürdenwiderstand zwecks einer Strom-Spannungstransformation vorgesehen.

Mit Vorteil sind die beiden Eingänge für die Stromerfassung bzw. Spannungserfassung mit einem Mess-Chip verbunden, der mittels einer programmierbaren Korrektureinrichtung um einen weiteren Abgleich einer Phasenkompensation zwischen Strom und Spannung besorgt ist. Eine besonders einfache und preiswerte Korrektureinrichtung bewirkt in engen Grenzen und nach Bedarf lediglich eine Verzögerung bzw. ein Nacheilen oder aber ein Voreilen der Spannungswerte gegenüber den Stromwerten in Abhängigkeit von der zuvor genannten Phasenkompensation mittels eines Hochpassfilters. Das Hochpassfilter kann dabei so gewählt werden, dass es einen Pauschalabgleich in Form eines Mindestabgleichs erzielt, sodass die Korrektureinrichtung des Mess-Chips in der Lage ist, die verbleibende Phasenkompensation mittels Verzögerung selbst vorzunehmen, oder aber, der Hochpass bewirkt einen Pauschalabgleich in Form eines Mittelabgteichs in den Kompensationsbereich der Korrektureinrichtung des Mess-Chips hinein.

Unter dem Begriff gleichstromtoleranter Wandler wird ein Stromwandler verstanden, der in der Lage ist, normgemäss eine Gleichstrombeaufschlagung von bis zu Iₘₐₓ/π unbeschadet zu vertragen, das heisst, dass ein derartiger gleichstromtoleranter Wandler selbst bei einer Mischstrombeaufschlagung mit einem Gleichanteil von Iₘₐₓ/π nicht in Sättigung geht und die zu messenden Wechselanteile bis auf eine Phasenverschiebung quasi fehlerfrei überträgt.

Der Einsatz der erfindungsgemässen Kompensationsschaltung erlaubt sogar die Verwendung herkömmlicher Mess-Chips, die von sich aus nicht in der Lage sind, Phasenverschiebungen, wie sie in Verbindung mit gleichstromtoleranten Wandlern auftreten können, zu korrigieren. Diese Kompensationsschaltung ermöglicht somit die normgerechte Verwendung konventioneller Mess-Chips in Verbindung mit diesen gleichstromtoleranten Wandlern.

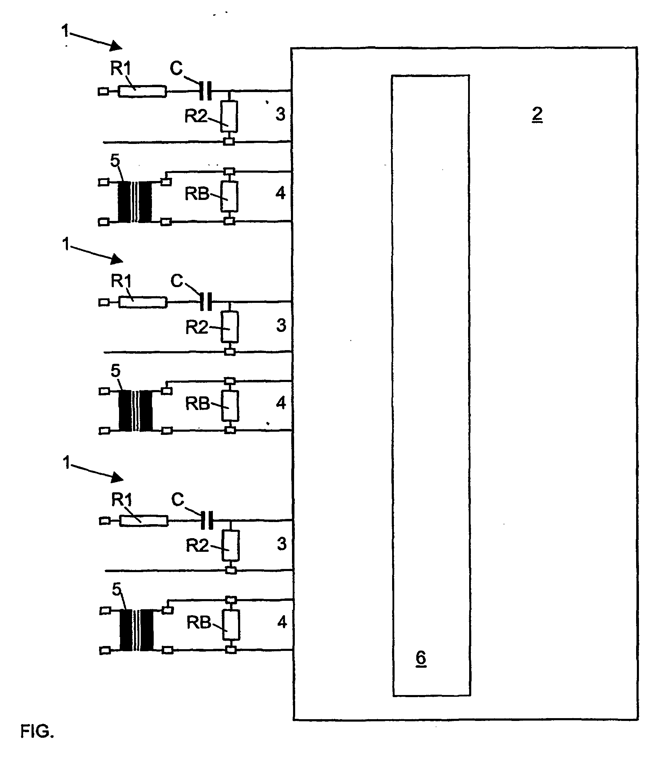

### KURZE BESCHREIBUNG DER ZEICHNUNG

In der Zeichnung ist ein Ausführungsbeispiel schematisch und vereinfacht dargestellt.
Es zeigt die einzige
- Fig.: eine erfindungsgemässe Kompensationsschaltung für elektronische Elektrizitätszähler zum direkten Anschluss.

### WEGE ZUR AUSFÜHRUNG DER ERFINDUNG

In der einzigen Fig. ist eine Messschaltungsanordnung 1 dargestellt, die für jede Phase eines Dreiphasennetzes jeweils einen Eingang 3 für die Spannungserfassung und einen Eingang 4 für die Stromerfassung aufweist Alle Eingänge 3, 4 für die Spannungserfassung bzw. Stromerfassung sind mit einem Mess-Chip 2 verbunden, der eine Korrektureinrichtung 6 zwecks einer Phasenkompensation umfasst. Vor jedem Eingang 3 für die Spannungserfassung ist ein Hochpassfilter, bestehend aus einem Widerstand R1 und einem Kondensator C, angeordnet, welches durch einen weiteren Widerstand R2 zwecks Spannungsteilung diesem Eingang 3 ergänzt sein kann. Jedem Eingang 4 für die Stromerfassung ist ein gleichstromtoleranter Wandler 5 vorgelagert, dem zwecks Transformation eines Stromsignals in ein Spannungssignal ein Bürdenwiderstand RB nachgeschaltet sein kann.

Die anhand der Fig. erläuterte Messschaltungsanordnung 1 mit nachgeschaltetem Mess-Chip 2 stellt eine Schaltung zur Messwerterfassung von Spannungssignalen und Stromsignalen für einen Elektrizitätszähler zum direkten Anschluss dar. Derartige Elektrizitätszähler gelangen in Haushalten zum Einsatz, das heisst, dass diese Elektrizitätszähler als Massenprodukte unter entsprechenden wirtschaftlichen Gesichtspunkten gefertigt werden. Sie müssen robust sein gegenüber Umgebungseinflüssen (Heizungskellerinstallation, Kellerinstallation, Etageninstallation), einfach herstellbar und preiswert sein.

Der gleichstromtolerante Wandler 5 im Strompfad zeigt im Hinblick auf Robustheit und Wirtschaftlichkeit gute Eigenschaften, allerdings weist er ebenfalls eine unerwünscht grosse Phasenwinkelverschiebung zwischen dem transformierten Stromsignal und dem vom Eingang 3 erfassten Spannungssignal auf. Diese Phasenverschiebung ist zum einen frequenzabhängig und zum anderen weitgehend im zu messenden Strombereich unabhängig von der Stromstärke, sodass mittels des Hochpassfilters R1, C vor dem Eingang 3 für die Spannungserfassung eine entsprechend angepasste - ebenfalls frequenzabhängige Phasenverschiebung bewirkt werden kann, womit eine im wesentlichen frequenzunabhängige Phasenkompensation zwischen der Stromerfassung und der Spannungserfassung erfolgt.

Diese hochpassgestützte Phasenkompensation ist derart ausgelegt, dass sie bis in den Bereich der möglichen Phasenkompensation der Korrektureinrichtung 6 des Mess-Chips 2 reicht. Eine Auslegung der hochpassgestützten Phasenkompensation sieht vor, dass dieser Abgleich als minimaler Mindestabgleich bis zum unteren Bereichsrand der Phasenkompensation der Korrektureinrichtung 6 reicht, oder aber in einer weiteren Auslegung in die Mitte dieses Bereiches der Phasenkompensation der Korrektureinrichtung 6 als Mittelabgleich hineinreicht. In beiden Auslegungsfällen handelt es sich jedoch um frequenzunabhängige Pauschalabgleiche, mit denen der wesentliche Teil der Phasenkompensation zwischen Stromerfassung und Spannungserfassung vorgenommen wird.

Die weitere Phasenkompensation wird dann durch die Korrektureinrichtung 6 des Mess-Chips 2 vollzogen. Da dieser Anteil der Phasenkompensation im Vergleich zur hochpassgestützten Phasenkompensation klein ist, kann in Kauf genommen werden, dass die Phasenkompensation mittels Korrektureinrichtung 6 frequenzabhängig ist. Eine einfache Ausführung der Korrektureinrichtung 6 sieht eine programmierbare Verzögerung vor, die mittels Software realisiert wird. Selbstverständlich ist im Sinne der Erfindung ebenfalls eine mittels Bauelementen realisierte, weitere Phasenkompensation durch die Korrektureinrichtung 6 denkbar.

Des weiteren kann die in der Fig. gezeigte dreiphasige Anordnung einer Messschaltungsanordnung auch lediglich einphasig ausgeführt sein, ohne dass eine erfinderische Leistung erbracht werden muss. In Sinne der Erfindung ist ebenfalls denkbar, dass anstatt des gezeigten Hochpassfilters, bestehend aus R1, C, beispielsweise ein R-L-Filter zum Einsatz vor dem Eingang 3 für die Spannungserfassung gelangt.

### BEZUGSZEICHENLISTE

- 1: Messschaltungsanordnung
- 2: Mess-Chip
- 3: Eingang für Spannungserfassung
- 4: Eingang für Stromerfassung
- 5: gleichstromtoleranter Wandler
- 6: Korrektureinrichtung
- R1: Widerstand
- R2: Widerstand
- C: Kondensator

## Patentansprüche

1. Kompensationsschaltung für die Phasenverschiebung zwischen einem ersten Eingang (3) für eine Spannungserfassung und einem zweiten Eingang (4) für eine Stromerfassung bei Elektrizitätszählern zum direkten Anschluss, wobei vor diesem zweiten Eingang (4) ein gleichstromtoleranter Wandler (5) angeordnet ist,
**dadurch gekennzeichnet,**
**dass** vor dem ersten Eingang (3) für die Spannungserfassung ein Hochpassfilter (R1, C) für einen ersten Abgleich zur frequenzunabhängigen Phasenkompensation angeordnet ist.

2. Kompensationsschaltung nach Anspruch 1, **dadurch gekennzeichnet, dass** das Hochpassfilter (R1, C) in Reihenschaltung einen ersten Widerstand (R1) und einen Kondensator (C) umfasst.

3. Kompensationsschaltung nach Anspruch 1 oder 2, **dadurch gekennzeichnet, dass** zwischen dem Hochpassfilter (R1, C) und dem ersten Eingang (3) für die Spannungserfassung ein zweiter Widerstand (R2) in Parallelschaltung zur Spannungsteilung angeordnet ist.

4. Kompensationsschaltung nach einem der Ansprüche 1 bis 3, **dadurch gekennzeichnet, dass** zwischen dem gleichstromtoleranten Wandler (5) und dem zweiten Eingang (4) für die Stromerfassung ein Bürdenwiderstand (RB) angeordnet ist.

5. Kompensationsschaltung nach einem der Ansprüche 1 bis 4, **dadurch gekennzeichnet, dass** eine frequenzabhängige Phasenverschiebung des Hochpassfilters (R1, C) annähernd gleich ist einer frequenzabhängigen Phasenverschiebung des gleichstromtoleranten Wandlers (5).

6. Kompensationsschaltung nach einem der Ansprüche 1 bis 5, **dadurch gekennzeichnet, dass** ein Mess-Chip (2) mit dem ersten und zweiten Eingang (3, 4) verbunden ist, wobei dieser Mess-Chip (2) eine programmierbare Korrektureinrichtung (6) für einen zweiten Abgleich der Phasenkompensation zwischen der Spannungserfassung und der Stromerfassung aufweist.

7. Kompensationsschaltung nach Anspruch 6, **dadurch gekennzeichnet, dass** der zweite Abgleich der Phasenkompensation frequenzabhängig ist.

## Claims

1. Compensation circuit for the phase shift between a first input (3) for a voltage determination and a second input (4) for a current determination in electricity meters for direct connection, whereby a DC-tolerant converter (5) is arranged before said second input (4), **characterised by** the fact that for the voltage determination a high-pass filter (R1, C) is arranged before the first input (3) for a first equalisation to the non-frequency-dependant phase compensation.

2. Compensation circuit according to claim 1, **characterised by** the fact that the high-pass filter (R1, C) comprises in series connection a first resistance (R1) and a condenser (C).

3. Compensation circuit according to claim 1 or 2, **characterised by** the fact that a second resistance (R2) is arranged in parallel connection for voltage division between the high-pass filter (R1, C) and the first input (3) for the voltage determination.

4. Compensation circuit according to one of the claims 1 to 3, **characterised by** the fact that a load resistor (RB) is arranged between the DC-tolerant converter (5) and the second input (4) for the current determination.

5. Compensation circuit according to one of the claims 1 to 4, **characterised by** the fact that a frequency-dependant phase shift of the high-pass filter (R1, C) is approximately equal to a frequency-dependant phase shift of the DC-tolerant converter (5).

6. Compensation circuit according to one of the claims 1 to 5, **characterised by** the fact that a measuring chip (2) is connected with the first and second inputs (3, 4), whereby this measuring chip (2) comprises a programmable correction device (6) for a second equalisation of the phase compensation between the voltage determination and the current determination.

7. Compensation circuit according to claim 6, **characterised by** the fact that the second equalisation of the phase compensation is frequency-dependant.

## Revendications

1. Circuit de compensation destiné au déphasage entre un premier accès (3) pour une saisie de tension et un deuxième accès (4) pour une saisie de courant lors de compteurs électriques pour connexion directe, auquel cas un transformateur tolérant un C.C. (5) est monté devant ce deuxième accès (4), **caractérisé par le fait que** pour la saisie de tension un filtre passe-haut (R1, C) est monté devant le premier accès (3) pour une première égalisation à une compensation de phase non sélective.

2. Circuit de compensation selon la revendication 1, **caractérisé par le fait que** le filtre passe-haut (R1, C) dans un couplage en série comprend une première résistance (R1) et un condensateur (C).

3. Circuit de compensation selon la revendication 1 ou 2, **caractérisé par le fait qu'**une deuxième résistance (R2) est montée dans un montage en parallèle pour la division de tension entre le filtre passe-haut (R1, C) et le premier accès (3) pour la saisie de tension.

4. Circuit de compensation selon une des revendications de 1 à 3, **caractérisé par le fait qu'**une résistance de charge (RB) est montée entre le transformateur tolérant un C.C. (5) et le deuxième accès (4) pour la saisie de courant.

5. Circuit de compensation selon une des revendications de 1 à 4, **caractérisé par le fait qu'**un déphasage sélectif du filtre passe-haut (R1, C) est approximativement identique à un déphasage sélectif du transformateur tolérant un C.C. (5).

6. Circuit de compensation selon une des revendications de 1 à 5, **caractérisé par le fait qu'**une puce de mesurage (2) est reliée au premier et au deuxième accès (3, 4), auquel cas cette puce de mesurage (2) présente un dispositif de correction (6) programmable pour une deuxième égalisation de la compensation de phase entre la saisie de tension et la saisie de courant.

7. Circuit de compensation selon la revendication 6, **caractérisé par le fait que** la deuxième égalisation de la compensation de phase est sélective.
